# EUROPEAN PATENT APPLICATION

(11) **EP 2 184 743 A1**
(43) Date of publication of application: **12.05.2010**
(21) Application number: 08828296.7
(22) Date of filing: 27.08.2008
(51) Int. Cl.: H01B 13/00, C23C 14/08, G02F 1/1343

(54) **CONDUCTOR LAYER MANUFACTURING METHOD**

(30) Priority: 29.08.2007 JP 2007222988
(71) Applicant: Asahi Glass Company, Limited, Chiyoda-ku Tokyo 100-8405 (JP)
(72) Inventor: YAMADA, Naoomi, Kawasaki-shi Kanagawa 213-0012 (JP); HITOSUGI, Taro, Kawasaki-shi Kanagawa 213-0012 (JP); HASEGAWA, Tetsuya, Kawasaki-shi Kanagawa 213-0012 (JP)
(74) Representative: Müller-Boré & Partner Patentanwälte
(86) International application number: PCT/JP2008/065333
(87) International publication number: WO 2009/028569

(57) **Abstract**

To provide a process capable of producing a titanium oxide electric conductor layer having excellent electric conductivity and good transparency, with high productivity.

A first layer and a second layer each made of titanium oxide doped with a dopant such as Nb, are formed in order on a substrate in a state where the substrate is heated to prepare an electric conductor layer comprising an electric conductor layer. The first layer is formed under film formation conditions under which it is a layer containing polycrystals which contain no rutile crystals. The second layer is formed under film formation conditions under which a layer containing polycrystals which contain rutile crystals is obtained when directly formed on a substrate.

## Description

### TECHNICAL FIELD

The present invention relates to a process for producing an electric conductor layer.

### BACKGROUND ART

In recent years, large-sized liquid crystal display panels and small-sized liquid crystal display panels for portable devices are increasingly demanded. In order to realize these, low power consumption of display elements is required, and application of transparent electrodes having high visible light transmittance and low resistance, is essential.

In particular, organic electroluminescence elements that are being developed recently, are self-emission type elements effectively applicable to small-sized portable devices, but they have a problem that they consume large power since they use a current-drive method. Further, plasma display panels (PDP) being widely spread in the market and field emission displays (FED) being developed as the next generation display, have a problem that they have a structure of high power consumption. From these reasons, low-resistance transparent electrically conductive thin films are highly expected.

As a typical example of transparent electrically conductive thin film is an indium tin oxide film (hereinafter referred to as ITO film) made of indium oxide doped with tin. An ITO film is excellent in transparency and has high electric conductivity, but it has a demerit that since the earth crust contains only 50 ppb of In, the raw material cost increases as In resource is exhausted.

In recent years, as a material of transparent electric conductor, titanium dioxide (TiO₂) having both chemical resistance and durability attracts attention (for example Non-Patent Document 1).

The following Patent Document 1 proposes a method of obtaining a transparent conductor by forming on a substrate a metal oxide layer of M:TiO₂ (M is e.g. Nb or Ta) having an anatase crystal structure. This document shows that a single crystal thin film (solid solution) of M:TiO₂ having an anatase crystal structure formed by epitaxial growth, significantly increases electric conductivity while it maintains transparency.

The following Patent Document 2 proposes a method of obtaining a layered structure of transparent electrically conductive thin film by forming on a transparent substrate body a layered structure in which a transparent high-refractive-index thin film layer containing hydrogen and a metal thin film layer are alternately layered. The transparent high-refractive-index thin film layer is made of e.g. titanium oxide.
Non-Patent Document 1: Oyo Butsuri (Applied Physics) Vol. 73, No. 5 (2004), p. 587-592
Patent Document 1: WO2006/016608
Patent Document 2: JP-A-2004-95240

### DISCLOSURE OF THE INVENTION

### OBJECT TO BE ACCOMPLISHED BY THE INVENTION

The single crystal thin film of M:TiO₂ having an anatase crystal structure described in Patent Document 1, is difficult to produce and is not likely to be practically used. The transparent refractive index thin film layer in Patent Document 2 tends to have insufficient transparency since it contains hydrogen at a time of forming the film. Thus, it is difficult to realize an electric conductor layer having low electric resistance and being excellent in transparency.

The present invention has been made considering the above-mentioned circumstances, and it is an object of the present invention to provide a process for producing a titanium oxide type electric conductor layer excellent in electric conductivity and having good transparency with high productivity.

### MEANS TO ACCOMPLISH THE OBJECT

In order to accomplish the above object, the present inventors have developed a method of forming a transparent electrically conductive film by forming a layer made of titanium oxide doped with a dopant such as Nb, followed by post annealing in a reducing atmosphere, and have filed an application for a patent (e.g. Japanese Patent Application No. 2007-59077). They have further conducted extensive studies and as a result, found a method of forming a transparent electrically conductive film without a post annealing step and accomplished the present invention.

That is, the present invention provides the following.
1. A process for producing an electric conductor layer, which comprises a first step of forming on a substrate a first layer made of titanium oxide doped with one or at least two selected from the dopant group consisting of Nb, Ta, Mo, As, Sb, Al, Hf, Si, Ge, Zr, W, Co, Fe, Cr, Sn, Ni, V, Mn, Tc, Re, P and Bi in a state where the substrate is heated under the following film formation conditions (1), and a second step of forming a second layer made of titanium oxide doped with one or at least two selected from the above dopant group on the above first layer in a state where the substrate is heated under the following film formation conditions (2):
   (1) film formation conditions under which in a monolayer film formation test, a layer containing polycrystals which contain no rutile crystals is obtained,
   (2) film formation conditions under which in a monolayer film formation test, a layer containing polycrystals which contain rutile crystals is obtained.
2. The process for producing an electric conductor layer according to the above 1, wherein the temperature of the substrate in the first step and in the second step is from 150 to 600°C.
3. The process for producing an electric conductor layer according to the above 1 or 2, wherein each of the content of the dopant in the first layer and the content of the dopant in the second layer is from 1 to 10 atomic% based on 100 atomic% of the total amount of titanium atoms (Ti) and dopant metal atoms (M).
4. The process for producing an electric conductor layer according to the above 1, 2 or 3, wherein the dopant group consists of Nb and Ta.
5. The process for producing an electric conductor layer according to any one of the above 1 to 4, wherein the electric conductor layer contains a polycrystalline layer and the polycrystalline layer contains no rutile crystal layer.
6. The process for producing an electric conductor layer according to any one of the above 1 to 5, wherein the thickness of the first layer is from 5 to 50 nm, and the total thickness of the first layer and the second layer is from 20 to 1,000 nm.
7. The process for producing an electric conductor layer according to any one of the above 1 to 6, wherein the crystal grain size of the electric conductor layer is from 0.2 to 1.5 µm.
8. The process for producing an electric conductor layer according to any one of the above 1 to 7, wherein the first layer and the second layer are formed by a sputtering method, and the concentration of an oxidizing sputtering gas in an atmospheric gas at the time of forming the second layer is lower than the concentration of an oxidizing sputtering gas in an atmospheric gas at the time of forming the first layer.
9. The process for producing an electric conductor layer according to any one of the above 1 to 8, wherein the first layer and the second layer are formed by a sputtering method, and the content of oxygen atoms in a target used for formation of the second layer is lower than the content of oxygen atoms in a target used for formation of the first layer.
10. The process for producing an electric conductor layer according to any one of the above 1 to 9, wherein the temperature of the substrate in the second step is higher than the temperature of the substrate in the first step.

### EFFECTS OF THE INVENTION

According to the present invention, it is possible to produce an electric conductor layer which has a layered structure comprising a first layer and a second layer each containing titanium oxide as the main component, and which is excellent in electric conductivity and has good transparency with high productivity.

### BRIEF DESCRIPTION OF THE DRAWINGS

Fig. 1 is a view illustrating a state where an electric conductor layer is laminated on a substrate.
Fig. 2 is views illustrating an example wherein a first layer and a second layer are formed by a sputtering method.
Fig. 3 is a diagram illustrating measurement results of a sample film obtained by a monolayer film formation test by X-ray diffraction (X-ray diffraction profile).
Fig. 4 is a diagram illustrating measurement results of a sample film obtained by a monolayer film formation test by X-ray diffraction (X-ray diffraction profile).
Fig. 5 is a diagram illustrating measurement results of an electric conductor layer according to the present invention by X-ray diffraction (X-ray diffraction profile).
Fig. 6 is a diagram illustrating measurement results of an electric conductor layer according to the present invention by X-ray diffraction (X-ray diffraction profile).
Fig. 7 is a graph illustrating the relation between the normalized peak intensity of the (101) peak of anatase crystals and the (110) peak of rutile crystals in the X-ray diffraction profile shown in Fig. 6, and the substrate temperature.
Fig. 8 is a diagram illustrating the dependence of the resistivity, the carrier density and the hall mobility of an electric conductor layer according to the present invention on the substrate temperature.
Fig. 9 is a diagram illustrating the dependence of the resistivity, the carrier density and the hall mobility of an electric conductor layer according to the present invention on the substrate temperature.
Fig. 10 is a diagram illustrating measurement results of an electric conductor layer according to the present invention by X-ray diffraction (X-ray diffraction profile).
Fig. 11 is a diagram illustrating measurement results of an electric conductor layer according to the present invention by X-ray diffraction (X-ray diffraction profile).
Fig. 12 is a diagram illustrating measurement results of an electric conductor layer according to the present invention by X-ray diffraction (X-ray diffraction profile).
Fig. 13 is diagrams illustrating measurement results of an electric conductor layer according to the present invention by X-ray diffraction (X-ray diffraction profile).
Fig. 14 is diagrams illustrating measurement results of the transmittance, the reflectivity and the absorptivity of a sample film obtained by a monolayer film formation test.
Fig. 15 is diagrams illustrating measurement results of the transmittance, the reflectivity and the absorptivity of a sample film obtained by a monolayer film formation test.
Fig. 16 is diagrams illustrating measurement results of the transmittance, the resistivity and the absorptivity of an electric conductor layer according to the present invention.
Fig. 17 is diagrams illustrating measurement results of the transmittance, the resistivity and the absorptivity of an electric conductor layer according to the present invention.
Fig. 18 is diagrams illustrating measurement results of the transmittance, the resistivity and the absorptivity of an electric conductor layer according to the present invention.

### MEANINGS OF SYMBOLS

10: Substrate
11: First layer
12: Second layer
13: Electric conductor layer

### BEST MODE FOR CARRYING OUT THE INVENTION

### {First embodiment}

A first embodiment of the present invention will be described in detail below.

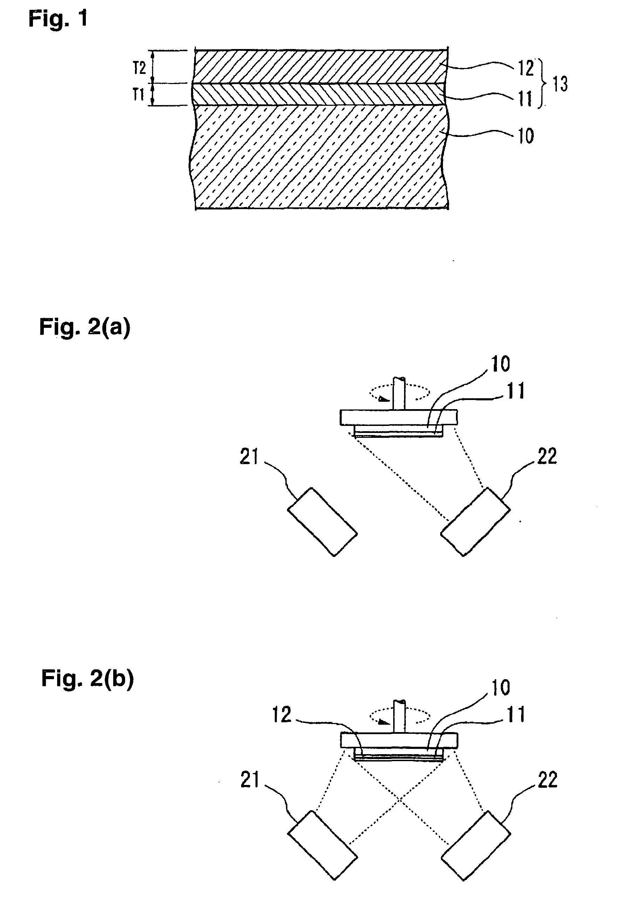

Fig. 1 is a cross-sectional view illustrating a process for producing an electric conductor layer according to the present embodiment. In this embodiment, a first layer 11 made of titanium oxide doped with a dopant is formed on a surface of a substrate (substrate body) 11 and a second layer 12 made of titanium oxide doped with a dopant is formed thereon to obtain an electric conductor layer 13.

The material of the substrate (substrate body 10) is not particularly limited. It may, for example, be a single crystal material, a polycrystal material, an amorphous material, or a material as a mixture of these states.

Specific examples include a substrate made of single crystal or polycrystal strontium titanate (SrTiO₃); a single crystal substrate or a polycrystal substrate made of a rock salt type crystal of perovskite crystal structure or a similar structure; a substrate made of single crystal or polycrystal gallium nitride; a single crystal substrate or a polycrystal substrate made of a nitride or an oxide of a zinc blende crystal of wurtzite crystal structure or a similar structure; a quartz substrate; a glass substrate made of a glass material such as non-alkali glass (for example, AN100, model name, manufactured by Asahi Glass Company, Limited or 1737, model name, manufactured by Corning Incorporated) or soda lime glass; a plastic substrate made of a plastic material such as a polyimide, a polyethylene terephthalate, a polyethylene naphthalate, triacetylacetonate, a polyethersulfone, a polycarbonate; a polyethylene, a polyvinyl chloride, a polypropylene or a polymethacrylate; and a semiconductor substrate such as a silicon substrate (thermally oxidized Si substrate) on a surface of which a thermally oxidized film is formed. These substrates may contain a dopant or an impurity within a range not diminishing effects of the present invention.

In a case of employing a single crystal substrate of SrTiO₃ as the substrate body, the substrate is preferably one finished so that the substrate surface corresponds to the (100) plane.

Further, in a case of employing a glass substrate as the substrate, the effect of the present invention is more greatly obtained since a layer having anatase crystals having good properties is hardly formed by a conventional method.

According to the process of the present invention, even in a case of a substrate body a part of whose surface is amorphous, a good electric conductor layer can be formed on a surface of the substrate body. In the present invention, the substrate body is preferably in a polycrystalline state, in an amorphous state or in a state where a polycrystalline state and an amorphous state are mixed.

The shape of the substrate body of the present invention is not particularly limited. For example, the substrate body may be a plate-shaped substrate 10 or a film shape such as a plastic film.

The thickness of the substrate 10 is not particularly limited. In a case where the transparency of the substrate 10 is required, the thickness is preferably at most 1 mm. In a case of a plate-shaped substrate 10 where a mechanical strength is required and the transmittance may be sacrificed to a certain extent, the thickness may be more than 1 mm. The thickness of the substrate 10 is preferably, for example, from 0.2 to 1 mm.

As the substrate 10, a polished substrate may be employed as the case requires. A substrate having crystallinity such as a SrTiO₃ substrate, is preferably polished for use. For example, such a substrate is mechanically polished by using a diamond slurry as an abrasive. In such a mechanical polishing, it is preferred to gradually reduce the grain size of the diamond slurry to be used, and to carry out mirror polishing with a diamond slurry having a grain size of about 0.5 µm in the final step. Thereafter, a further polishing with a colloidal silica may be carried out to obtain a surface roughness of 10 Å (1 nm) or less in terms of root mean square (rms) roughness.

Before forming a first layer 11, the substrate 10 may be preliminarily processed. This preliminary process may, for example, be carried out in the following steps. First of all, the substrate is cleaned with e.g. acetone or ethanol. Then, the substrate is immersed in high-purity hydrochloric acid (for example, EL grade, concentration: 36 mass%, manufactured by Kanto Chemical Co., Ltd.) for 2 minutes. Then, the substrate is moved into purified water to wash out e.g. the hydrochloric acid. Then, the substrate is moved into new purified water and subjected to ultrasonic cleaning for 5 minutes. Subsequently, the substrate is taken out from the purified water, and nitrogen gas is blown against the substrate surfaces to remove water from the substrate surfaces. These treatments are carried out, for example, at room temperature. By these treatments, e.g. oxides and organic substances are considered to be removed from the substrate surfaces. In the above example, hydrochloric acid is used, but instead of this, an acid such as nitrohydrochloric acid or hydrofluoric acid may be used. The treatment with the acid may be carried out at room temperature or a heated acid may be used.

Each of the first layer 11 and the second layer 12 is made of titanium oxide doped with one or at least two dopants selected from the group consisting of Nb, Ta, Mo, As, Sb, Al, Hf, Si, Ge, Zr, W, Co, Fe, Cr, Sn, Ni, V, Mn, Tc, Re, P and Bi. The titanium oxide of the present invention is one in which Ti sites of TiO₂ are substituted by metal atoms M (dopant), and hereinafter it may be referred to as "M:TiO₂". In the present specification, "titanium oxide" and "TiO₂" include "TiO_{2-δ}" (δ is the oxygen deficiency amount) unless otherwise specified.

In the first layer 11 and the second layer 12, the content of impurities other than the dopant metal atoms (M), oxygen atoms (O) and titanium atoms (Ti) is preferably at most 0.1 atomic%.

Particularly, when Nb, Ta, Mo, As, Sb, Al, Hf, Si, Ge, Zr or W is employed as a dopant, improvement of electric conductivity is expected while transparency of the electric conductor layer 13 to visible light is maintained. Further, when Co, Fe, Cr, Sn, Ni, V, Mn, Tc, Re, P or Bi is employed as a dopant, magneto-optics effects or ferromagnetism is expected.

Among the above-mentioned dopants, it is preferred to employ Nb, Ta, Mo, As, Sb or W, and particularly, it is preferred to employ Nb and/or Ta in terms of improving electric conductivity.

The dopant added in the first layer 11 and the dopant added in the second layer 12 may be the same or different. Each of the content of the dopant in the first layer 11 and the content of the dopant in the second layer 12 is preferably more than 0 atomic% and at most 50 atomic%, provided that the total amount of titanium atoms (Ti) and dopant metal atoms (M) is 100 atomic% (this definition is applied hereinafter). If the content is more than 50 atomic%, the characteristic of TiO₂ as a matrix material becomes weak. More preferably, the content is at most 20 atomic%, particularly preferably at most 10 atomic%. Further, in order to satisfactory obtain high transparency and low resistance, the content is more preferably at least 1 atomic%. The content of the dopant in the first layer 11 and the content of the dopant in the second layer 12 may be the same or different.

Further, it is possible to adjust light-transmittance characteristics of the electric conductor layer 13 by the content of the dopant. For example, by increasing Nb doping amount, it is possible to cut a red region of longer wavelength so that the electric conductor layer 13 only transmits blue light.

First, the first layer 11 is formed on the substrate 10 in a state where the substrate 10 is heated (first step), and then, the second layer 12 is formed on the first layer 11 in a state where the substrate 10 is heated (second step).

Each of the first layer 11 and the second layer 12 can be formed by appropriately using a known film forming method. Specifically, a physical vapor deposition (PVD) method such as a pulsed laser deposition (PLD) method or a sputtering method; a chemical vapor deposition (CVD) method such as a MOCVD method; or a film forming method by a synthesizing process from a solution such as a sol gel method or a chemical solution method.

Particularly, a PLD method is preferred since it produces good film conditions, and a sputtering method is preferred since uniform film formation on a large area substrate is easy.

In a case where the sputtering method is employed, preferred is a method of forming a first layer 11 on a substrate 10 by a reactive sputtering method in an atmospheric gas containing an oxidizing sputtering gas, and then forming a second layer 12 on the first layer 11 by a reactive sputtering method in an atmospheric gas containing an oxidizing sputtering gas. As a sputtering apparatus, a known apparatus can be appropriately used. For example, a reactive DC magnetron sputtering apparatus can be used.

Specifically, a target and a substrate 10 are set in a vacuum chamber of the sputtering apparatus. The target is attached to a magnetron cathode constituted such that a magnet is disposed on the rear side to generate a magnetic field with a predetermined intensity in a space in front of the target. The vacuum chamber is evacuated of air by a pump to be in a vacuum state, and then a sputtering gas is introduced to adjust the flow ratio and the pressure of the oxidizing sputtering gas to be predetermined values. Then, a predetermined voltage is applied to the target to deposit a first layer 11 on the substrate by sputtering. The pressure during film formation i.e. the sputtering pressure is preferably from 0.1 to 5.0 Pa, more preferably from 0.3 to 3.0 Pa.

The target to be used for film formation may be a metal target or a metal oxide target or may be both in combination. The metal target may, for example, be a titanium alloy doped with a predetermined amount of a dopant. The metal oxide target may, for example, be a TiO₂ sintered body doped with a predetermined amount of a dopant. For example, a Nb:TiO₂ sintered body can be prepared by mixing powders of TiO₂ and Nb₂O₅ weighed to have a desired atomic ratio and sintering the mixed powder. One type of a target may be doped with a plurality of dopants.

The content of the dopant in the target is substantially equal to the content of the dopant in the film formed by using the target. Accordingly, it is preferred to set the dopant content in the target depending on the aimed dopant content in the first layer 11 or the second layer 12.

In the composition of the metal oxide target, the ratio of the atomicity of O to the atomicity of Ti (O/Ti ratio) is preferably within a range of from 0.5 to 2.0. That is, preferred is titanium oxide (M:TiO_{2-δ}: 0≦δ≦1.5). If the O/Ti ratio is lower than this range, the film is likely to be colored, and it is difficult to satisfy both high transparency and high electric conductivity. An oxide having an O/Ti ratio higher than this range is difficult to prepare. When the O/Ti ratio is within a range of from 1.0 to 2.0, both transparency and electric conductivity of the film tend to be satisfied. Further, when the O/Ti ratio is within a range of from 1.5 to 2.0, a film having higher transparency will be obtained.

The crystal structure of the metal oxide target may be any of rutile type, anatase type, brookite type and Magneli phase, or may be a mixture thereof.

As the sputtering gas, at least an oxidizing sputtering gas is preferably used, and more preferably, a mixed gas of an oxidizing sputtering gas and an inert gas is used. As the inert gas, one or at least two selected from the group consisting of Ar, He, Ne, Kr and Xe may be used. As the oxidizing sputtering gas, one or at least two selected from the group consisting of O₂, O₃, H₂O and CO₂ may be used. In view of the safety and maintenance of a film formation apparatus, it is preferred to use O₂ as the oxidizing sputtering gas.

The concentration of the oxidizing sputtering gas in the atmospheric gas at the time of film formation may be adjusted by the ratio of the flow rate of the oxidizing sputtering gas to the total flow rate of sputtering gases introduced to the vacuum chamber (hereinafter sometimes referred to as the oxidizing sputtering gas flow ratio). For example, in a case where a mixed gas of an oxidizing sputtering gas and an inert gas is used as the sputtering gas, the total flow rate of sputtering gases is the total amount of the flow rate of the oxidizing sputtering gas and the flow rate of the inert gas.

The first layer 11 is formed under film formation conditions (1) under which when a monolayer film formation test is carried out by the following method, a layer containing polycrystals which contain no rutile crystals is obtained, and the second layer 12 is formed under the film formation conditions (2) under which when a monolayer film formation test is carried out, a layer containing polycrystals which contain rutile crystals is obtained.

The monolayer film formation test in the present invention is carried out in the following procedure.

First, in a state where a thermally oxidized Si substrate is heated at 300°C, a sample film having a thickness of 150 nm is formed on the surface of the substrate. As the thermally oxidized Si substrate, a silicon substrate of which the surface is covered with a thermally oxidized film comprising SiO₂ having a thickness of 200 nm is used. The sample film is formed on the thermally oxidized film by sputtering.

In the present specification, the film formation conditions for the first layer and the second layer are conditions other than the type of the substrate, the substrate temperature and the film thickness, to be employed for formation of the first layer 11 and the second layer 12, respectively, which will influence reproducibility of the crystal states of the films. Specifically, in the case of the film formation by the sputtering method, they are the composition of the target, the composition of the atmospheric gas, the sputtering pressure, the magnetic field intensity, the electric power applied to the target, the distance between the target and the substrate, the ultimate vacuum in the film formation chamber before introduction of the atmospheric gas, and the sintered density of the target. Among them, it is the composition of the atmospheric gas that has a great influence over the crystal state.

Then, an X-ray diffraction profile of the formed sample film is measured by an X-ray diffraction apparatus. In the obtained X-ray diffraction profile, presence or absence of (101) and (004) peaks of anatase crystals which appear by priority and are characteristically observed when anatase polycrystals are formed, and (110) and (200) peaks of rutile crystals which appear by priority and are characteristically observed when rutile polycrystals are formed, is observed. When none of these four peaks is observed, the sample film is judged to be an amorphous layer. When at least one peak among these four peaks is observed, the sample film is judged to be a layer containing polycrystals, and when at least one of (110) and (200) peaks of the rutile crystals is observed, the polycrystals are judged to contain rutile crystals, and when none of these two peaks is observed or the peak intensity is sufficiently low relative to the peak intensity of the anatase crystals, the polycrystals are judged to contain no rutile crystals.

As a result of judgment, in a case where the sample film is a layer containing polycrystals which contain no rutile crystals, the film formation conditions other than the type of the substrate, the substrate temperature and the film thickness under which the sample film was formed, can be employed as the film formation conditions (1) for formation of the first layer 11.

On the other hand, as a result of the judgment, in a case where the sample film is a layer containing polycrystals which contain rutile crystals, the film formation conditions other than the type of the substrate, the substrate temperature and the film thickness under which the sample film was formed, can be employed as the film formation conditions (2) for formation of the second layer 12.

In the monolayer film formation test, a sample layer containing polycrystals is formed since the substrate temperature is 300°C. When the film formation conditions are conditions such that the oxygen content in the film is low, the sample layer tends to contain rutile crystals. The pressure at the time of film formation of the first layer 11 and the second layer 12, i.e. the sputtering pressure is preferably from 0.1 to 5.0 Pa, more preferably from 0.2 to 3.0 Pa. As a method of controlling the oxygen content in the film, a method (A) of adjusting the concentration of the oxidizing sputtering gas in the atmospheric gas at the time of film formation and a method (B) of adjusting the oxygen atom content in the target used at the time of film formation may be mentioned. The method (A) and the method (B) may be combined.

In the case of the above method (A), the concentration of the oxidizing sputtering gas in the atmospheric gas can be controlled, specifically, by the oxidizing sputtering gas flow ratio in the atmospheric gas to be introduced at the time of the film formation. The lower the oxidizing sputtering gas flow ratio relative to the content of oxygen atoms in one target, the lower the oxygen content in the film. For example, in a case where the target is made of titanium oxide doped with a dopant M (M:TiO_{2-δ}: 0≦δ1≦1.5), as the film formation conditions (1) for the first layer 11, the oxidizing sputtering gas flow ratio is preferably at least 0.1 vol%, more preferably at least 0.25 vol%. The upper limit of the oxidizing sputtering gas flow ratio may be 100 vol%.

On the other hand, as the film formation conditions (2) for the second layer 12, the oxidizing sputtering gas flow ratio is preferably less than 10 vol%, more preferably at most 5 vol%, furthermore preferably less than 0.1 vol%, and it may be 0 vol%. Further, no oxidizing sputtering gas may be contained in the sputtering gas for forming the second layer 12, and hydrogen (H₂) gas may be contained. In such a case, the hydrogen gas flow ratio relative to the total flow rate of the sputtering gas is preferably at least 1 vol% and at most 50 vol%. If the hydrogen gas flow ratio is lower than the above range, the effect of adding the hydrogen gas tends to be insufficient, and if it is higher than the above range, metal titanium may be formed by excessive reduction.

Further, in a case where the target is made of a metal, as the film formation conditions (1) for the first layer 11, the oxidizing sputtering gas flow ratio is preferably at least 7.5 vol%, more preferably at least 10 vol%. It may be 100 vol%.

On the other hand, as the film formation conditions (2) for the second layer 12, the oxidizing sputtering gas flow ratio is preferably at least 3 vol% and at most 7.5 vol%, more preferably at least 5 vol% and at most 7 vol%. When the oxidizing sputtering gas flow ratio is lower than the above range, metal titanium may be formed due to insufficient oxidation.

The concentration of the oxidizing sputtering gas in the atmospheric gas at the time of forming the second layer is preferably lower than the concentration of the oxidizing sputtering gas in the atmospheric gas at the time of forming the first layer, in view of formation of a layer having high transparency and high electric conductivity. Further, in such a case, the types of the respective oxidizing gases are preferably the same.

In the case of the method (B), the content of oxygen atoms in the target used for film formation can be reduced by film formation using a metal target 21 and a metal oxide target 22 simultaneously as shown in Fig. 2, as compared with a case of film formation by using a metal oxide target alone.

Specifically, both metal target 21 and metal oxide target 22 are preliminarily set in a vacuum chamber to face a substrate 10. Then, a voltage is applied to the metal target 21 and/or the metal oxide target 22 to form a film on the substrate 10 while rotating the substrate 10. The dopant contents in the metal target 21 and in the metal oxide target 22 are preferably the same.

In this method, in a case where the concentration of the oxidizing sputtering gas in the atmospheric gas is constant and the sizes of the metal target 21 and the metal oxide target 22 are the same, the higher the ratio of "the electric power applied to the metal target/the electric power applied to the metal oxide target", the lower the oxygen content in the film.

The content of oxygen atoms in the target used for formation of the second layer 12 is preferably lower than the content of oxygen atoms in the target used for formation of the first layer 11, in view of formation of a layer having high transparency and high electric conductivity. Further, in such a case, the dopant contents in the respective targets are preferably the same.

For example, in a case where a metal oxide target 22 made of a metal oxide (M:TiO_{2-δ}: 0≦δ2≦1.5) and a metal target 21 made of an alloy of M and Ti are used, and the oxidizing sputtering gas flow ratio at the time of forming the first layer 11 and at the time of forming the second layer 12 is constant within a range of at least 0.1 vol%, to form the first layer 11, it is preferred that a voltage is applied only to the metal oxide target 22 and that the voltage applied to the metal target 21 is 0 as shown in Fig. 2(a).

Then, to form second layer 12, as shown in Fig. 2(b), a voltage is applied to both the metal target 21 and the metal oxide target 22. For example, in a case where the discharge manner of the metal oxide target is RF discharge, the discharge manner of the metal target is DC discharge, and the areas of the targets are the same, to satisfy the above film formation conditions (1) and/or the film formation conditions (2), the ratio of the electric power (unit: W) applied to the metal target is preferably from 5 to 40% based on the electric power (unit: W) applied to the metal oxide target being 100%.

If the temperature of the substrate i.e. the substrate temperature in the first step and the second step for formation of the first layer 11 and the second layer 12 is too low, the first layer 11 and the second layer 12 may not sufficiently be crystallized. The substrate temperature at the time of film formation is preferably at least 150°C, more preferably at least 200°C. In order to obtain an electric conductor layer 13 having a sufficiently low resistivity, it is more preferably at least 225°C, particularly preferably at least 250°C.

On the other hand, if the substrate temperature at the time of film formation is too high, rutile phase disadvantageous for reduction of the resistance is likely to be formed, and accordingly the substrate temperature is preferably at most 600°C. It is more preferably at most 450°C to further suppress formation of the rutile phase. In order to obtain an electric conductor layer 13 having a sufficiently low resistivity, it is more preferably at most 400°C, particularly preferably at most 350°C.

The substrate temperature in the first step and the substrate temperature in the second step may be the same or different, and in order to further improve the electric conductivity of the electric conductor layer 13, the substrate temperature in the second step is preferably higher than the substrate temperature in the first step. The substrate temperature in the second step is higher than the substrate temperature in the first step preferably by at least 20°C, more preferably by at least 30°C. In such a case, the substrate temperature in the first step is preferably within a range of from 225 to 350°C, more preferably within a range of from 250 to 300°C. The substrate temperature in the second step is preferably higher than the substrate temperature in the first step and at most 400°C.

The film thickness T1 of the first layer 11 is preferably at least 5 nm and at most 50 nm, more preferably at least 10 nm and at most 40 nm. When the film thickness is within the above range, an electric conductor layer 13 having a low resistivity and having excellent transparency to visible light can be obtained. Further, favorable characteristics of the carrier density and the hall mobility can also be obtained. The film thickness T2 of the second layer 12 is not particularly limited and is preferably set depending on the desired thickness of the electric conductor layer 13.

The thickness of the electric conductor layer 13 comprising the first layer and the second layer is not particularly limited and is optionally set depending on the purpose of use, etc. The thickness of the electric conductor layer 13 is preferably from 20 to 1,000 nm, more preferably from 100 to 200 nm.

As shown in the after-mentioned Examples, in a case where a layer is formed directly on a substrate under the above film formation conditions (2) (monolayer film formation test), a layer containing rutile crystals is obtained. However, when the second layer 12 is formed on the first layer 11 in a state where the substrate is heated, an electric conductor layer 13 in which formation of rutile crystals is remarkably suppressed is obtained. This is a surprising phenomenon. Further, an electric conductor layer 13 obtained by forming the second layer 12 on the first layer 11 has a remarkably low resistivity and a remarkably high transmittance to visible light as compared with a layer formed directly on a substrate under the film formation conditions for the second layer 12.

Further, as shown in the after-mentioned Examples, the electric conductor layer 13 obtained by forming the first layer 11 and the second layer 12 in order while the substrate is heated, has a remarkably low resistivity as compared with a case where only the first layer 11 is formed while the substrate is heated, although they are the same in that they are layers made of polycrystals which contain no rutile crystals.

The above behavior is considered to be because the first layer substantially comprising an anatase single phase functions as a seed layer to stabilize the anatase structure of the second layer formed on the first layer, so that the anatase polycrystals are likely to be formed in the second layer formed under the film formation conditions (2) under which the oxygen content in the film becomes low. Further, since formation of the rutile crystals is suppressed in the second layer, the electric conductor layer has a high transmittance to visible light and excellent transparency.

The crystal grain size of the electric conductor layer can be obtained by observing the surface of the electric conductor layer by a polarizing microscope or an AFM (atomic force microscope). In the present specification, the crystal grain size means the arithmetic mean of circle-equivalent crystal grain sizes observed with respect to all the crystal grains observed in the field. Here, the circle-equivalent crystal grain size means a diameter of a circle having the same area as the crystal grain. By use of a polarizing microscope, the crystal grain sizes can be measured in a region of 100 µm × 100 µm with respect to a polycrystalline film having a circle-equivalent crystal grain size of at least 1 µm, and by use of an AFM, in a region of 5 µm × 5 µm with respect to a polycrystalline film having a circle-equivalent crystal grain size of at least 0.01 µm.

The crystal grain size of the electric conductor layer of the present invention is preferably from 0.2 to 1.5 µm, more preferably from 0.3 to 1.1 µm. If it is less than 0.1 µm, crystallization has not sufficiently proceeded, whereby no favorable electric conductivity will be obtained. If it exceeds 1.5 µm, a great stress may occur in the electric conductor layer.

The visible light transmittance of the electric conductor layer of the present invention is preferably at least 85%.

According to the present embodiment, an electric conductor layer 13 having low resistance and high transparency can be realized, particularly, a high transmittance to visible light can be achieved. Accordingly, such a layer is suitable as an electric conductor layer for which transparency is required.

Further, at a time of forming the single crystal thin film of M:TiO₂ having an anatase crystal structure by an epitaxial method described in Patent Document 1, alignment of crystals in a substrate is important and strict control of production conditions is required. On the other hand, according to the production process of the present invention, an electric conductor layer can be formed not only on a glass substrate but also on a plastic surface or a silicon substrate such as an amorphous silicon substrate, and thus, wider range of substrate selection is possible and production becomes easy. Accordingly, the productivity is high, and application of the electric conductor layer is wide. Further, an electric conductor layer 13 as an electric conductive layer can be obtained only by forming the first layer 11 and the second layer 12 in order while the substrate is heated. Accordingly, it is not necessary to carry out a post annealing step separately from the film formation process, and thus the process is simple, the productivity is high, and the production time saving is likely to be realized.

### {Second embodiment}

In the first embodiment, the first layer and the second layer are formed on a substrate by a sputtering method, but they may be formed by a PLD method (pulsed laser deposition method). In this embodiment, conditions other than the following conditions are the same as those in the first embodiment.

In the PLD method, for example, a substrate and a target are disposed to face each other in a chamber which can maintain an appropriate depressurized state, oxygen gas is injected into the chamber and at the same time, the oxygen partial pressure in the chamber is maintained a predetermined value, and the substrate temperature is set at a predetermined temperature, and while the substrate and the target are rotated, the target is intermittently irradiated with a pulsed laser light to rapidly increase the temperature of the surface of the target to produce abrasion plasma. Ti atoms, O atoms and M (dopant) atoms contained in the abrasion plasma gradually change their state as they repeatedly collide and react with oxygen gas in the chamber and move to the substrate, and particles containing Ti atoms, M atoms and O atoms reached the substrate are, as they are, deposited on the substrate to form a thin film.

As the pulsed laser light, for example, KrF excimer laser light having a pulse frequency of from 1 to 10 Hz, a laser fluence (laser power) of from 1 to 2 J/cm² and a wavelength of 248 nm may be used. The pressure in the exhaust side of the chamber is preferably always maintained to be 10⁻³ Torr (1.33×10⁻¹ Pa) or lower.

The substrate and the target in this embodiment are the same as those in the first embodiment. The target in this embodiment contains the same type of the dopant in the same content as the first embodiment. As the target, for example, a metal oxide target is used. The metal oxide target is the same as in the first embodiment. In this embodiment also, the content of the dopant in the target is substantially the same as the content of the dopant in the film to be formed by using the target.

The film formation conditions for the first layer and the second layer according to this embodiment are, in the same manner as the film formation conditions in the first embodiment, conditions other than the type of the substrate, the substrate temperature and the film thickness, to be employed for formation of the first layer and the second layer, respectively, which will influence reproducibility of the crystal states of the films. Specifically, they are the composition of the target, the oxygen partial pressure in the atmosphere, the wavelength of the pulsed laser light, the pulse frequency, the laser fluence (laser power), the pulse width, the distance between the target and the substrate, the ultimate vacuum in the film formation chamber before introduction of the atmospheric gas, and the sintered density of the target, and among them, it is the oxygen partial pressure in the atmosphere and the laser fluence (laser power) that has a great influence over the crystal state.

In this embodiment, as the film formation conditions (1) or (2), as a method to control the oxygen content in the film, it is preferred to employ a method (C) of controlling the oxygen partial pressure at the time of film formation.

In a case where the content of oxygen atoms in the target is constant, the lower the oxygen partial pressure at the time of film formation, the lower the oxygen content in the film. For example, in a case where the target is made of titanium oxide doped with a dopant M (M:TiO_{2-δ3}: 0≦δ3≦1.5), the oxygen partial pressure for forming the first layer 11 is preferably at least 5×10⁻¹ Pa, more preferably at least 1×10° Pa. Further, in view of the productivity, the upper limit of the oxygen partial pressure is preferably at most 1×10⁵ Pa.

On the other hand, the oxygen partial pressure for forming the second layer 12 is preferably less than 5×10⁻¹ Pa, more preferably at most 3×10⁻¹ Pa. Further, with a view to securing transparency, the lower limit of the oxygen partial pressure is preferably at least 1×10⁻⁸ Pa.

In this embodiment, the film thickness T1 of the first layer 11 and the film thickness T2 of the second layer 12 are the same as in the first embodiment.

### EXAMPLES

Now, the present invention will be described in further detail with reference to Examples, but the present invention is by no means restricted to such specific Examples.

In the following, as the measurement methods, the following methods were used. Measurement was carried out at room temperature (20 to 25°C) unless otherwise specified.

### {X-ray diffraction profile}

Measured by an X-ray diffraction apparatus manufactured by Bruker Japan Co., Ltd. (model: D8Discover, X-ray source: CuKα, acceleration voltage: 40 kV, electric current: 40 mA).

### {Optical characteristics}

Measurement of optical characteristics was carried out with respect to a sample prepared in the same manner except that a 1737 glass substrate manufactured by Corning Incorporated was used, by using a spectrophotometer manufactured by JASCO Corporation. The visible light transmittance was determined in accordance with JIS R3106. The absorptivity (%) was obtained by subtracting the total of the transmittance (%) and the reflectivity (%) obtained by the measurement from 100%. That is, it was calculated from absorptivity (%) = 100 - (transmittance + reflectivity) (%).

### {Crystal grain size}

The surface of the electric conductor layer was observed by a polarizing microscope or an AFM to evaluate the crystal grain size of the electric conductor layer.

### MONOLAYER FILM FORMATION TEST EXAMPLE 1

Main production conditions are shown in Table 1. That is, a reactive DC magnetron sputtering apparatus was used to form a titanium oxide film doped with Nb on a substrate. As the substrate, a thermally oxidized Si substrate comprising a Si substrate having a thickness of 0.625 mm and having a thermally oxidized film having a thickness of 200 nm formed thereon was used.

First, in a vacuum chamber of the reactive DC magnetron sputtering apparatus, a titanium oxide sintered body containing 4 atomic% of Nb as a metal oxide target was set and in addition, the substrate was set.

Then, the vacuum chamber was evacuated of air to 5×10⁻⁴ Pa or lower by a pump, and a mixed gas of Ar gas and O₂ gas as a sputtering gas was introduced into the vacuum chamber so that the flow ratio of the O₂ gas to the total flow rate of the Ar gas and the O₂ gas i.e. the oxidizing sputtering gas flow ratio became 1.0 vol%, and the pressure (sputtering pressure) in the vacuum chamber was adjusted to be 1.0 Pa.

Then, an electric power of 100 W was applied to the target to form a titanium oxide film (sample film) doped with Nb on the substrate heated and held at 300°C in the mixed gas atmosphere of Ar gas and the O₂ gas. The film thickness was 150 nm.

The Nb content of the obtained sample film was 4 atomic%.

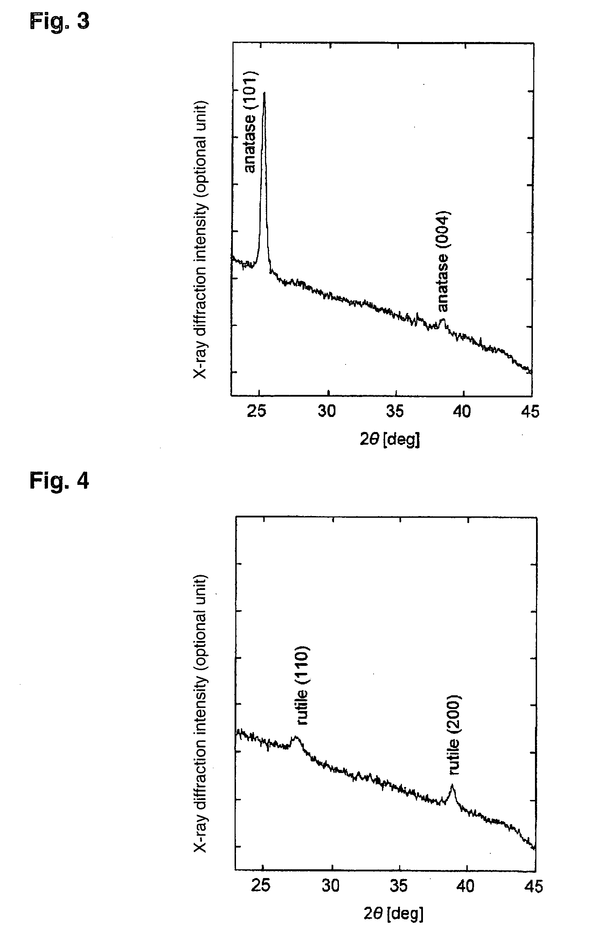

X-ray diffraction was carried out with respect to the obtained sample film. The obtained X-ray diffraction profile is shown in Fig. 3. In the X-ray diffraction profile, the X-ray diffraction intensity at the vertical axis is normalized by the Si (004) peak (the same applies hereinafter).

In this diagram, the (101) peak and the (004) peak of the anatase crystals are observed, but no (110) peak nor (200) peak of the rutile crystals are confirmed. That is, this sample film is a layer containing polycrystals which contain no rutile crystals. Accordingly, the film formation conditions other than the type of the substrate, the substrate temperature and the film thickness in this Example can be employed as the film formation conditions (1) for formation of the first layer.

The obtained sample film had a resistivity of higher than 10⁵ Ωcm and was electrically insulating. The visible light transmittance of a glass substrate provided with the sample film in this Example was 87%. Further, the crystal grain size of the obtained sample film was 0.54 µm.

### MONOLAYER FILM FORMATION TEST EXAMPLE 2

The main production conditions are shown in Table 1. That is, a sample film in this Example was formed in the same manner as in the above Monolayer Film Formation Test Example 1 except that the oxidizing sputtering gas flow ratio was changed to 0%. The obtained sample film had a Nb content of 4 atomic%.

X-ray diffraction was carried out with respect to the obtained sample film. The obtained X-ray diffraction profile is shown in Fig. 4. In this Fig., the (110) peak and the (200) peak of the rutile crystals are observed, and accordingly the sample film in this Example is found to be a layer containing polycrystals which contain rutile crystals. Accordingly, the film formation conditions other than the type of the substrate, the substrate temperature and the film thickness in this Example can be employed as the film formation conditions (2) for formation of the second layer.

The resistivity and the visible light transmittance of the obtained sample film was 4×10⁻² Ωcm and 60%, respectively, and the crystal grain size was 0.15 µm.

**TABLE 1**

| | Monolayer Film Formation Test Example 1 | Monolayer Film Formation Test Example 2 |
|---|---|---|
| Substrate | Thermally oxidized Si substrate | Same as on the left |
| Target | Nb:TiO₂ sintered body containing 4 atomic% of Nb | Same as on the left |
| Sputtering gas | Mixed gas of O₂ and Ar | Ar gas alone |
| O₂ flow ratio | 1.0 vol% | 0 vol% |
| Sputtering pressure | 1.0 Pa | Same as on the left |
| Magnetron magnet field intensity | 250 G | Same as on the left |
| Electric power applied to target | 100 W | Same as on the left |
| Substrate temperature at the time of film formation | 300°C | Same as on the left |
| Film thickness | 150 nm | Same as on the left |
| Measurement results | Figs. 3 and 14 | Figs. 4 and 15 |
| Resistivity (Ωcm) | Higher than 1×10⁵ | 4×10⁻² |

### EXAMPLE 1

A first layer was formed on a thermally oxidized Si substrate, and then a second layer was formed to form an electric conductor layer. The main production conditions are shown in Table 2.

The substrate was the same as in the Monolayer Film Formation Test Example. The film formation conditions for the first layer were the same as in the Monolayer Film Formation Test Example 1, and the film formation conditions for the second layer are the same as in the Monolayer Film Formation Test Example 2. The substrate temperature at the time of forming the first layer (hereinafter sometimes referred to as the first substrate temperature or T1) and the substrate temperature at the time of forming the second layer (hereinafter sometimes referred to as the second substrate temperature or T2) were the same at 300°C (T1=T2=300°C). The film thickness of the first layer was 30 nm, and the film thickness of the second layer was 150 nm.

Specifically, after the first layer was formed, a shutter before the target was closed, and the electric power applied to the target was turned off. Then, the gas introduction was terminated, the chamber was evacuated of air by a vacuum pump, pure Ar gas was introduced to the chamber, and an electric power was applied to the target in an atmosphere with an oxidizing sputtering gas flow ratio of 0 vol% to form a second layer. The film thicknesses of the first layer and the second layer were controlled by adjusting the film formation time depending on the film formation rate at the time of forming each layer.

The obtained electric conductor layer had a Nb content of 4 atomic%.

**TABLE 2**

| | Ex. 1 | |
|---|---|---|
| | First layer | Second layer |
| Substrate | Thermally oxidized Si substrate | |
| Target | Same as in Monolayer Film Formation Test Example 1 | Same as in Monolayer Film Formation Test Example 2 |
| Sputtering gas | | |
| O₂ flow ratio | | |
| Sputtering pressure | | |
| Magnetron magnet field intensity | | |
| Electric power applied to target | | |
| Substrate temperature at the time of film formation | 300°C | 300°C |
| Film thickness | 30 nm | 150 nm |
| Measurement results | Figs. 5 and 16 | |
| Resistivity (Ωcm) | 2×10⁻³ | |

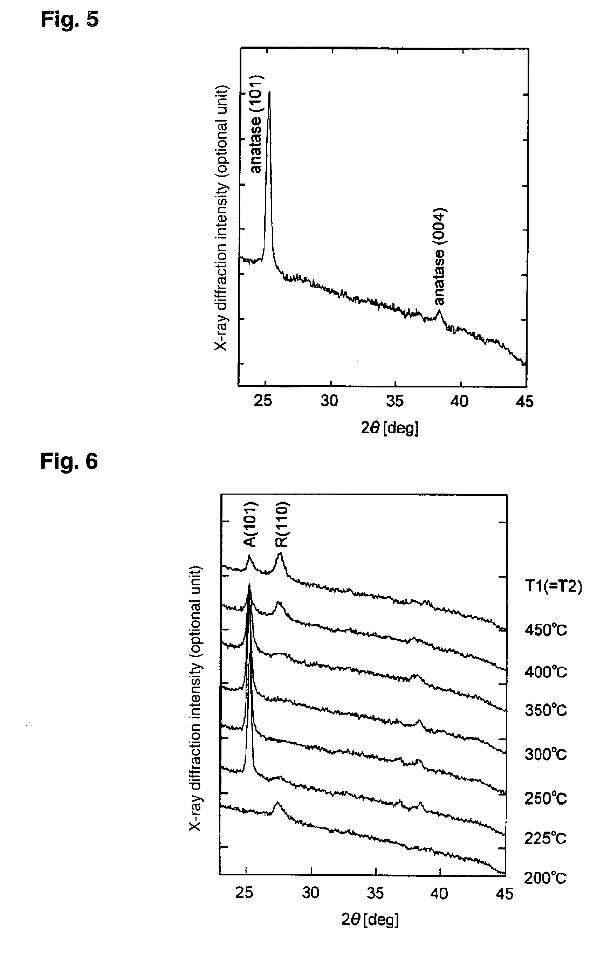

X-ray diffraction was carried out with respect to the obtained electric conductor layer. The obtained X-ray diffraction profile is shown in Fig. 5. In this Fig., the (101) peak and the (004) peak of the anatase crystals are observed, but no (110) peak nor (200) peak of the rutile crystals are confirmed. That is, in the electric conductor layer in this Example, the second layer was a layer containing polycrystals which contain no rutile crystals, even though it was formed under film formation conditions under which rutile crystals were formed in the monolayer film formation test. Further, the crystal grain size of the electric conductor layer in this Example was 0.67 µm.

The resistivity of the obtained electric conductor layer was measured, whereupon it was 2×10⁻³ Ωcm. That is, it was found that the electric conductor layer in this Example had a remarkably low resistivity although it is the same as the sample film (Fig. 3) obtained in Monolayer Film Formation Test Example 1 in that they are layers containing polycrystals which contain no rutile crystals. Further, the visible light transmittance of a glass substrate provided with the electric conductor layer in this Example was 87%.

### (COMPARISON OF MONOLAYER FILM FORMATION TEST EXAMPLES 1 AND 2 AND EXAMPLE 1)

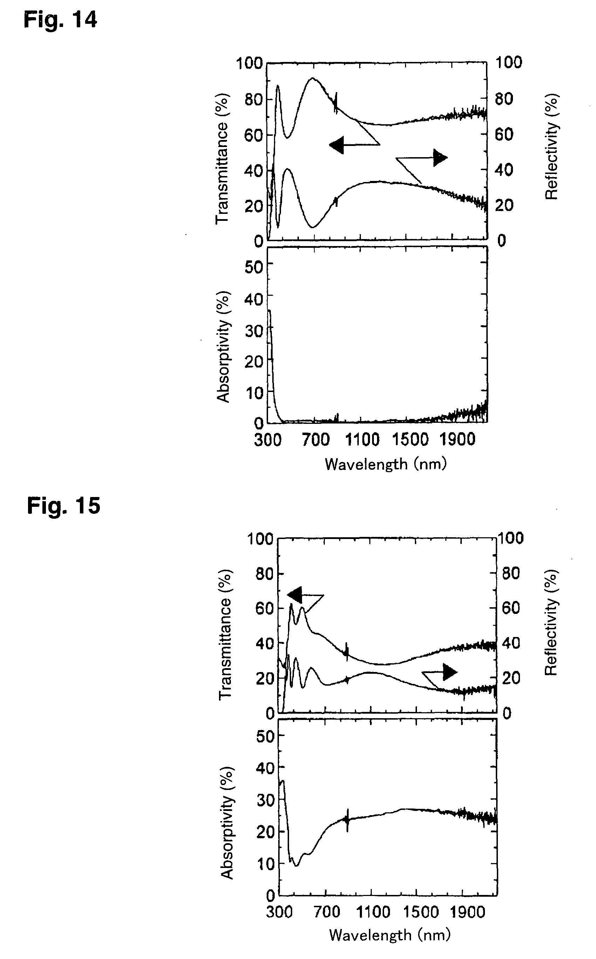

Graphs showing spectral characteristics of the sample film obtained in Monolayer Film Formation Test Example 1, the sample film obtained in Monolayer Film Formation Test Example 2 and the electric conductor layer obtained in Example 1 are shown in Figs. 14, 15 and 16, respectively. The vertical axes represent the transmittance T (%), the reflectivity R (%) and the absorptivity (%), and the lateral axes represent the wavelength.

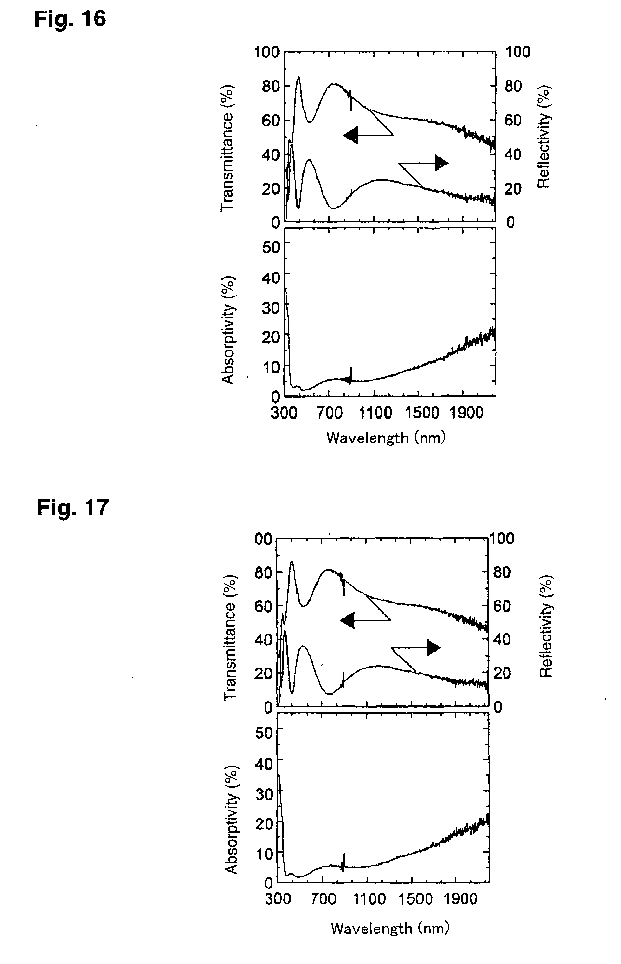

From the results, it was confirmed that the electric conductor layer (Fig. 16) obtained in Example 1 has a high transmittance in the visible region and has good transparency to visible light. Further, it has a high visible light transmittance as compared with the sample film (Fig. 15) obtained in Monolayer Film Formation Test Example 2.

Further, the sample film (Fig. 14) obtained in Monolayer Film Formation Test Example 1 has a high transmittance in the visible region but has a very high resistivity as shown in Table 1.

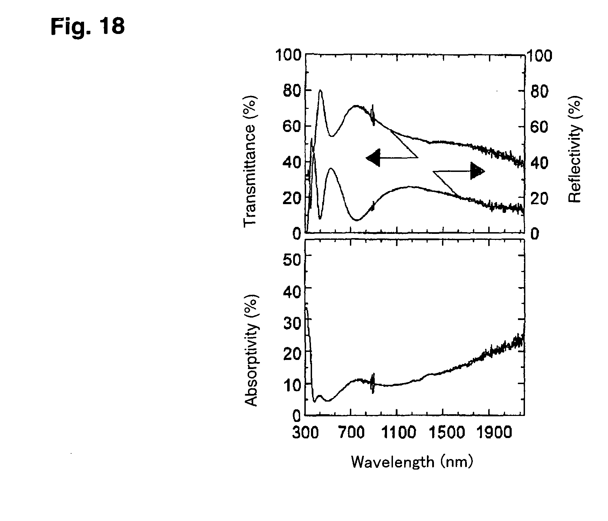

Fig. 17 is graphs illustrating the results of measuring the transmittance T, the reflectivity R and the absorptivity of an electric conductor layer when T1=250°C and T2=300°C in Example 3, and Fig. 18 is graphs illustrating the measurement results with respect to an electric conductor layer when T1=250°C and T2=350°C in Example 3.

The resistivities of these two electric conductor layers are the same as shown in Table 4. When the optical characteristics are compared, both layers have good transparency, but a layer of T1=250°C and T2=300°C (Fig. 17) has a lower light absorptivity and higher transparency.

### EXAMPLE 2

An electric conductor layer was formed in the same manner as in Example 1 except that the first substrate temperature and the second substrate temperature were the same (T1=T2) and changed to 7 stages of 200°C, 225°C, 250°C, 300°C (corresponding to Example 1), 350°C, 400°C and 450°C. All the obtained electric conductor layers had a Nb content of 4 atomic%.

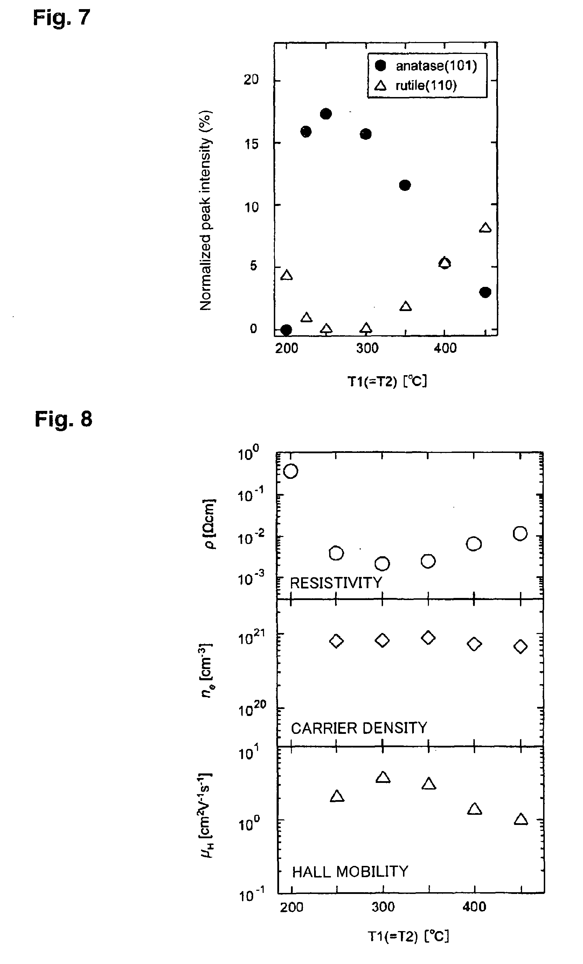

X-ray diffraction was carried out with respect to the obtained electric conductor layers. The obtained X-ray diffraction profiles are shown in Fig. 6. Further, a graph obtained by plotting the normalized peak intensity obtained by normalizing intensities of the (101) peak of the anatase crystals and the (110) peak of the rutile crystals in each X-ray diffraction profile by the Si (004) peak intensity on the vertical axis and the first and second substrate temperatures T1 and T2 (T1=T2, unit: °C) on the lateral axis, is shown in Fig. 7. ● represents the (101) peak intensity of the anatase crystals, and △ represents the (110) peak intensity of the rutile crystals. Further, the crystal grain size of the electric conductor layer in this Example was from 0.34 to 0.70 µm.

Further, with respect to the electric conductor layers obtained in this Example, the resistivity, the carrier density and the hall mobility were measured. The results are shown in Table 3 and Fig. 8. In Fig. 8, the lateral axes represent the substrate temperature (unit: °C), and the vertical axes represent the resistivity, the carrier density and the hall mobility.

From the results shown in Figs. 6 and 7, in this Example, the (101) peak intensity of the anatase crystals is highest, and the crystallinity of the anatase phase is highest at T1 and T2 of 250°C. Further, from the results shown in Fig. 8, it is found that the resistivity is lowest at T1 and T2 of 300°C. Further, the visible light transmittances of glass substrates provided with the electric conductor layer in this Example were from 84% to 88%

**TABLE 3**

| T1 (=T2) (°C) | Resistivity (Ωcm) | Carrier density (cm⁻³) | Hall mobility (cm²/(V·s)) |
|---|---|---|---|
| 250 | 3.9×10⁻³ | 8.0×10²⁰ | 2.0 |
| 300 | 2.1×10⁻³ | 8.1×10²⁰ | 3.6 |
| 350 | 2.5×10⁻³ | 8.5×10²⁰ | 3.0 |
| 400 | 6.4×10⁻³ | 7.3×10²⁰ | 1.3 |
| 450 | 9.4×10⁻³ | 6.8×10²⁰ | 1.0 |

### EXAMPLE 3

From the results in Example 2, the present inventors have considered that the resistivity can be more reduced by employing the different temperatures as the first substrate temperature (T1) and the second substrate temperature (T2) and conducted this Example. That is, electric conductor layers in this Example were formed in the same manner as in Example 1 except that the first substrate temperature T1 was fixed at 250°C and the second substrate temperature was changed to 4 stages of 300°C, 350°C, 400°C and 450°C. All the obtained electric conductor layers had a Nb content of 4 atomic%.

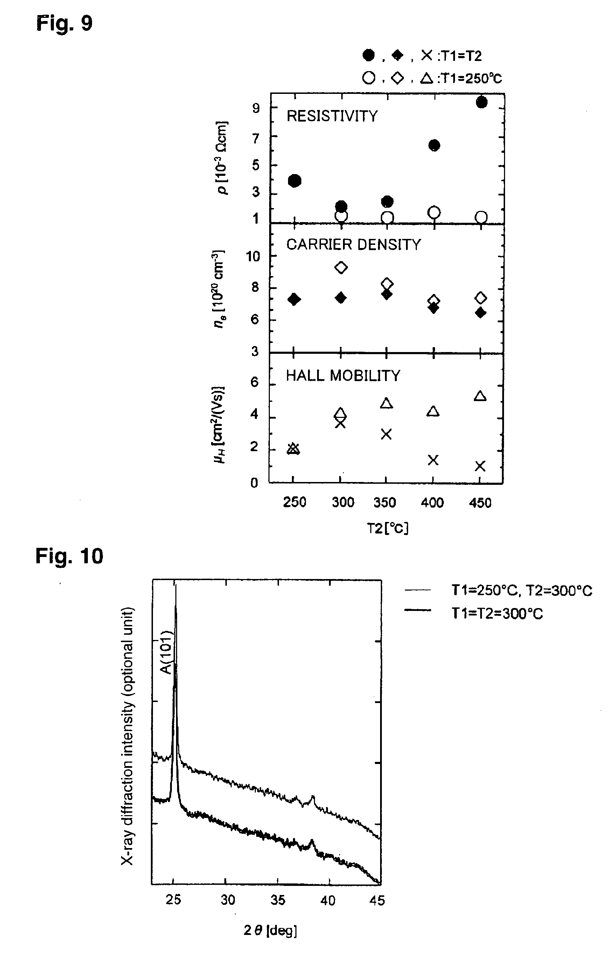

The resistivity, the carrier density and the hall mobility of the respective electric conductor layers obtained in this Example were measured. The results are shown in Table 4 and shown in Fig. 9 by ○, ◇ and △. In this Fig., the lateral axes represent the second substrate temperature (T2, unit: °C), and the vertical axes represent the resistivity, the carrier density and the hall mobility, and the results are shown together with the measurement results in Example 2 represented by • ,◆ and × for comparison.

**TABLE 4**

| T2 (°C) | T1 (°C) | Resistivity (Ωcm) | Carrier density (cm⁻³) | Hall mobility (cm²/(V·S)) |
|---|---|---|---|---|
| 300 | 250 | 1.4×10⁻³ | 1.1×10²¹ | 4.2 |
| 350 | 250 | 1.4×10⁻³ | 9.5×10²⁰ | 4.8 |
| 400 | 250 | 1.8×10⁻³ | 7.9×10²⁰ | 4.4 |
| 450 | 250 | 1.5×10⁻³ | 8.2×10²⁰ | 5.3 |

Further, X-ray diffraction was carried out with respect to the electric conductor layers in this Example wherein the first substrate temperature T1 was 250°C and the second substrate temperature T2 was 300°C, 350°C or 400°C. The obtained X-ray diffraction profiles are shown in Figs. 10 to 12. Further, for comparison, the X-ray diffraction profiles when T1 and T2 were the same (corresponding to Fig. 6) are shown in the same Figs. Further, the crystal grain sizes of the electric conductor layers in this Example were from 0.69 to 0.73 µm.

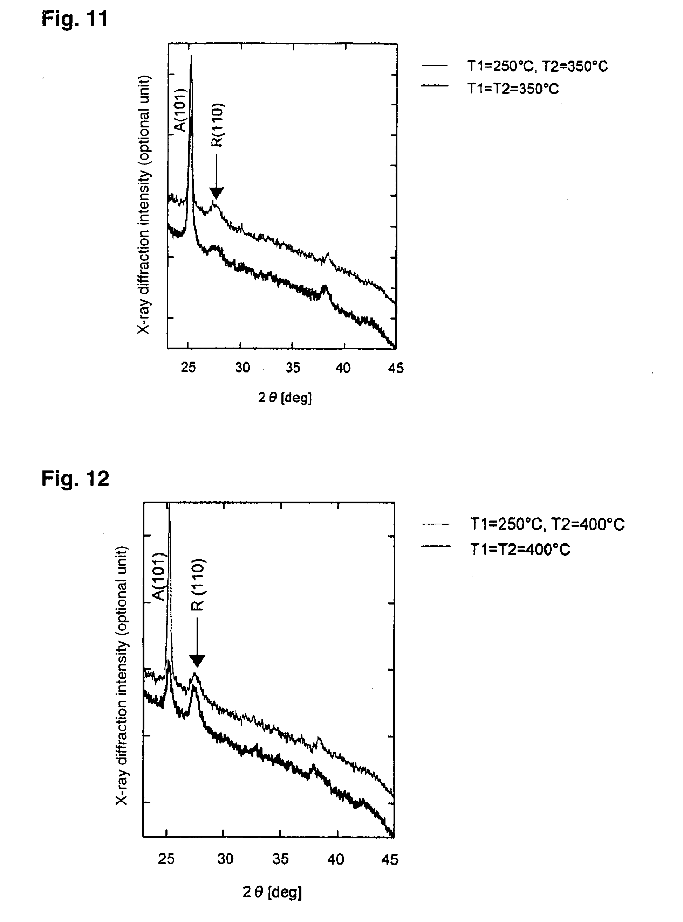

Fig. 10 is an X-ray diffraction profile of the electric conductor layer in this Example wherein T1=250°C and T2=300°C, Fig. 11 is a profile wherein T1=250°C and T2=350°C and Fig. 12 is a profile wherein T1=250°C and T2=400°C, and they are shown together with the X-ray diffraction profiles wherein T1 and T2 were the same at 300°C, 350°C and 400°C, respectively (corresponding to Fig. 6).

From the results shown in Fig. 9, it is found that a lower resistivity is obtained when T2 is higher than T1 as compared with a case where T2 and T1 are the same.

In Figs. 10 to 12, when the (101) peak of the anatase crystals is noted, the peak intensity is increased when T2 is higher than T1 as compared with a case where T2 and T1 are the same, and it is confirmed that the crystallinity of the anatase phase was improved.

The visible light transmittances of glass substrates provided with the electric conductor layer in this Example were from 83 to 88%.

### EXAMPLE 4

An electric conductor layer was formed in the same manner as in Example 1 except that the first substrate temperature T1 was 300°C and the second substrate temperature T2 was 250°C so that T2<T1. The obtained electric conductor layer had a Nb content of 4 atomic%.

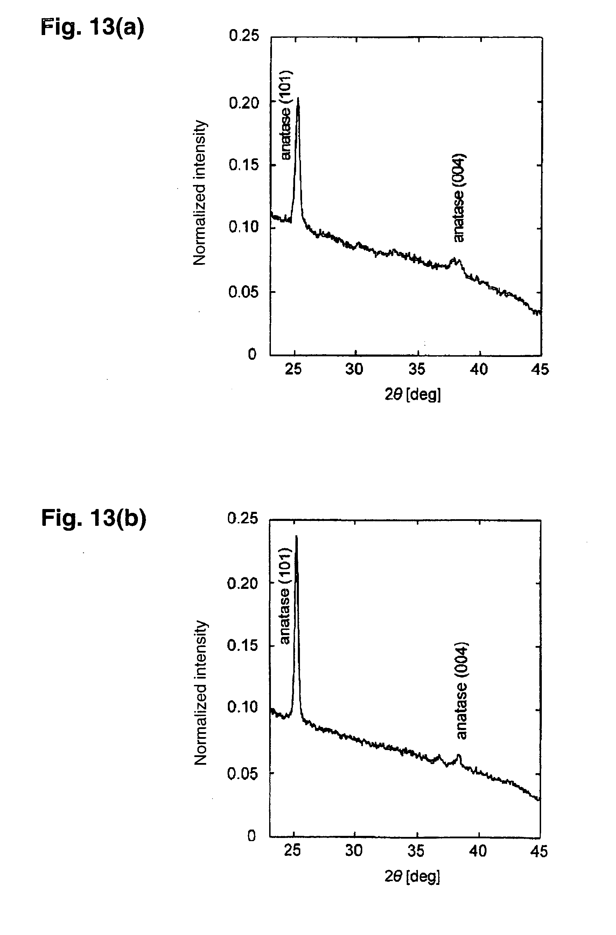

The obtained X-ray diffraction profile with respect to the electric conductor layer in this Example is shown in Fig. 13(a). The vertical axis represents the normalized peak intensity normalized by the Si (004) peak. For comparison, the X-ray diffraction profile in Example 3 shown in Fig. 10, wherein T1=250°C and T2=300°C, plotted in the same manner, is shown in Fig. 13(b).

The resistivity, the carrier density and the hall mobility of the electric conductor layer in this Example were as follows.
Resistivity: 1.8×10⁻² Ωcm
Carrier density: 6.8×10²⁰ cm⁻³
Hall mobility: 0.5 cm²/(V·s)

As compared with the electric conductor layer in Example 3 wherein T1=250°C and T2=300°C (T2>T1) shown in Fig. 13(b), of the electric conductor layer in this Example shown in Fig. 13(a) (T1=300°C and T2=250°C (T2<T1)), the (101) peak of the anatase crystals is broader, and the peak intensity is low also. Further, as compared with the results of measuring the electric conductivity of the electric conductor layer in Example 3 shown in Table 4, it is found that the electric conductor layer in this Example has a high resistivity and a low electric conductivity. Accordingly, it is confirmed that making the second substrate temperature (T2) higher than the first substrate temperature (T1) (T2>T1) is preferred to further improve the crystallinity of the anatase phase and to further lower the resistivity of the electric conductor layer.

### MONOLAYER FILM FORMATION TEST EXAMPLE 3

In the above Examples, the first layer and the second layer were formed by a method of changing the oxidizing sputtering gas flow ratio of the first step and the second step. However, the first layer and the second layer can be favorably formed by a method of changing the content of oxygen atoms in targets to be used for film formation, as follows. Further, both the methods may be used in combination.

In this Example, as shown in Fig. 2, a metal target 21 made of a Ti-Nb alloy containing 4 atomic% of Nb and the same metal oxide target 22 as in Monolayer Film Formation Test Example 1 are simultaneously set in a reactive DC magnetron sputtering apparatus to form a sample film doped with Nb on a substrate. The main film formation conditions are shown in Table 5.

As the substrate, the same thermally oxidized Si substrate as in Monolayer Film Formation Test Example 1 is used. As the sputtering gas, a mixed gas of Ar gas and O₂ gas is used.

First, in a vacuum chamber of the reactive DC magnetron sputtering apparatus, a metal target 21 and a metal oxide target 22 are set to a magnetron cathode to apply a predetermined magnetic field to the space in front of the targets and in addition, a substrate 10 is set, and the vacuum chamber is evacuated of air to 5×10⁻⁴ Pa or lower by a pump. Then, Ar gas and O₂ gas are introduced into the vacuum chamber so that the oxidizing sputtering gas flow ratio becomes 1.0 vol%, the pressure (sputtering pressure) in the vacuum chamber is adjusted to be 1.0 Pa, and an electric power of 150 W is applied to the metal oxide target 22 to form a titanium oxide film doped with Nb (sample film) on the substrate 10 heated and held at 300°C by sputtering. No electric power is applied to the metal target 21. The film thickness is 150 nm.

The sample film thus obtained is confirmed to be a layer containing polycrystals which contain no rutile crystals by an X-ray diffraction profile. Accordingly, the film formation conditions other than the type of the substrate, the substrate temperature and the film thickness in this Example can be employed as the film formation conditions (1) for formation of the first layer.

### MONOLAYER FILM FORMATION TEST EXAMPLE 4

A sample film is formed in the same manner as in the above Monolayer Film Formation Test Example 3 except that an electric power of 150 W is applied to the metal oxide target 22 and at the same time, an electric power of 40 W is applied to the metal target 21. The main film formation conditions are shown in Table 5.

The sample film thus obtained is confirmed to be a layer containing polycrystals which contain rutile crystals by an X-ray diffraction profile. Accordingly, the film formation conditions other than the type of the substrate, the substrate temperature and the film thickness in this Test Example 4 can be employed as the film formation conditions (2) for formation of the second layer.

Electric conductor layers equivalent to the electric conductor layers in Examples 1 to 4 are obtained by forming a first layer and a second layer in order on a thermally oxidized Si substrate under the film formation conditions for formation of the first layer other than the type of the substrate, the substrate temperature and the film thickness being the same as in Monolayer Film Formation Test Example 3, and under the film formation conditions for formation of the second layer other than the type of the substrate, the substrate temperature and the film thickness being the same as in Monolayer Film Formation Test Example 4.

**TABLE 5**

| | Monolayer Film Formation Test Example 3 | Monolayer Film Formation Test Example 4 |
|---|---|---|
| Substrate | Thermally oxidized Si substrate | Same as on the left |
| Target | Metal oxide (sintered body) and metal (alloy) | Same as on the left |
| Sputtering gas | Mixed gas of O₂ and Ar | Same as on the left |
| O₂ flow ratio | 1.0 vol% | Same as on the left |
| Sputtering pressure | 1.0 Pa | Same as on the left |
| Magnetron magnet field intensity | Metal oxide: 250 G Metal: 1000 G | Same as on the left |
| Electric power applied to target | Metal oxide: 150 W Metal: 0 W | Metal oxide: 150 W Metal: 40 W |
| Substrate temperature at the time of film formation | 300°C | Same as on the left |
| Film thickness | 150 nm | Same as on the left |

### INDUSTRIAL APPLICABILITY

The electric conductor layer of the present invention is widely applicable, and is applicable to transparent electrodes of e.g. flat panel displays, solar cells or touch panels. Further, it may be applicable to shielding of electromagnetic waves to be used for antireflective films, films for preventing adhesion of dust due to static electricity, antistatic films, heat-radiation-reflective glass or UV-reflective glass. By forming a multilayer film comprising a layer of SiO₂ and a TiO₂ layer doped with Nb, the multilayer film can be used also as an antireflective film.

Examples of application may be electrodes of dye-sensitized solar cells; transparent electrodes for display panels, EL panels, light-emitting elements, light-emitting diodes (LEDs), white LEDs or lasers; transparent electrodes of surface-emission type lasers; illumination devices; communication devices; applications transmitting light of only a predetermined wavelength region.

Further, as specific applications, the following applications may be mentioned: transparent electric conductive films in liquid crystal displays; transparent electric conductive films in color filters; transparent electric conductive films in organic EL displays; transparent electric conductive films in plasma displays (PDPs); PDP optical filters; transparent electric conductive films for shielding electromagnetic waves; transparent electric conductive films for shielding near infrared rays; transparent electric conductive films for preventing surface reflection; transparent electric conductive films for improving color reproducibility; transparent electric conductive films for preventing breakage; optical filters; touch panels; resistance film type touch panels; electromagnetic induction type touch panels; ultrasonic type touch panels; optical type touch panels; electrostatic capacitance type touch panels; resistance film type touch panels for portable information devices; touch panels (inner touch panels) integrated with displays; solar cells; amorphous silicon type solar cells; fine crystal Si thin film solar cells; CIGS solar cells; dye-sensitized solar cells; transparent electric conductive materials for preventing electrostatic of electric components; antistatic transparent electric conductive materials; light-control materials; light-control mirrors; heating elements such as surface heaters and electric heating glasses; electromagnetic wave shielding glasses.

The entire disclosure of Japanese Patent Application No. 2007-222988 filed on August 29, 2007 including specification, claims, drawings and summary is incorporated herein by reference in its entirety.

## Claims

1. A process for producing an electric conductor layer, which comprises a first step of forming on a substrate a first layer made of titanium oxide doped with one or at least two selected from the dopant group consisting of Nb, Ta, Mo, As, Sb, Al, Hf, Si, Ge, Zr, W, Co, Fe, Cr, Sn, Ni, V, Mn, Tc, Re, P and Bi in a state where the substrate is heated under the following film formation conditions (1), and a second step of forming a second layer made of titanium oxide doped with one or at least two selected from the above dopant group on the above first layer in a state where the substrate is heated under the following film formation conditions (2):
(1) film formation conditions under which in a monolayer film formation test, a layer containing polycrystals which contain no rutile crystals is obtained,
(2) film formation conditions under which in a monolayer film formation test, a layer containing polycrystals which contain rutile crystals is obtained.

2. The process for producing an electric conductor layer according to Claim 1, wherein the temperature of the substrate in the first step and in the second step is from 150 to 600°C.

3. The process for producing an electric conductor layer according to Claim 1 or 2, wherein each of the content of the dopant in the first layer and the content of the dopant in the second layer is from 1 to 10 atomic% based on 100 atomic% of the total amount of titanium atoms (Ti) and dopant metal atoms (M).

4. The process for producing an electric conductor layer according to Claim 1, 2 or 3, wherein the dopant group consists of Nb and Ta.

5. The process for producing an electric conductor layer according to any one of Claims 1 to 4, wherein the electric conductor layer contains a polycrystalline layer and the polycrystalline layer contains no rutile crystal layer.

6. The process for producing an electric conductor layer according to any one of Claims 1 to 5, wherein the thickness of the first layer is from 5 to 50 nm, and the total thickness of the first layer and the second layer is from 20 to 1,000 nm.

7. The process for producing an electric conductor layer according to any one of Claims 1 to 6, wherein the crystal grain size of the electric conductor layer is from 0.2 to 1.5 µm.

8. The process for producing an electric conductor layer according to any one of Claims 1 to 7, wherein the first layer and the second layer are formed by a sputtering method, and the concentration of an oxidizing sputtering gas in an atmospheric gas at the time of forming the second layer is lower than the concentration of an oxidizing sputtering gas in an atmospheric gas at the time of forming the first layer.

9. The process for producing an electric conductor layer according to any one of Claims 1 to 8, wherein the first layer and the second layer are formed by a sputtering method, and the content of oxygen atoms in a target used for formation of the second layer is lower than the content of oxygen atoms in a target used for formation of the first layer.

10. The process for producing an electric conductor layer according to any one of Claims 1 to 9, wherein the temperature of the substrate in the second step is higher than the temperature of the substrate in the first step.
